# EUROPEAN PATENT APPLICATION

(11) **EP 1 496 138 A1**
(43) Date of publication of application: **12.01.2005**
(21) Application number: 03723116.4
(22) Date of filing: 15.04.2003
(51) Int. Cl.: C23C 16/46, H01L 21/205

(54) **PROCESSING SYSTEM, PROCESSING METHOD AND MOUNTING MEMBER**

(30) Priority: 16.04.2002 JP 2002113414
(71) Applicant: TOKYO ELECTRON LIMITED, Minato-ku, Tokyo 107-8481 (JP)
(72) Inventor: KANNAN, Hiroshi, c/o Tokyo Electron Limited, Tokyo 107-8481 (JP)
(74) Representative: Liesegang, Eva
(86) International application number: PCT/JP2003/004774
(87) International publication number: WO 2003/087430

(57) **Abstract**

A target for processing (W) is placed on a placing member (21) that is in a chamber (12). The placing member (21) comprises a resistive layer (25). A power source (28) forms a magnetic field around an induction coil (27) by passing a current through the induction coil (27) that is provided on the out side of the chamber (12). The resistive layer (25) is heated by induction heating that occurs by the formed magnetic field, and heats the target for processing (W) that is placed on the placing member (21).

## Description

### Technical Field

The present invention relates to a processing device, processing method, and placing member, for heating a target for processing, such as a semiconductor wafer, etc., to a predetermined temperature, and processing the target for processing.

### Background Art

In the manufacturing process of semiconductor devices and liquid crystal display devices, etc., processing for forming predetermined kinds of films on substrates, such as semiconductor wafers, etc., are carried out. As the integration of a circuit that is formed on a substrate becomes high, or as the circuit that is formed on a substrate scales down, or as the film formed on a substrate becomes thinner, advancement of the film that is formed, becomes a large problem.

As a method for forming high quality films, the ALD (Atomic Layer Deposition) method is developed.

In a case of forming a predetermined kind of film, source gas is provided to a forming surface, where the film is to be formed. Molecules of the source gas attach to the forming surface in many layers. The ALD method applies the difference of the adsorption energy that the first molecular layer has towards the forming surface, with the adsorption energy that the molecular layers after the second layer has towards the forming surface. By this difference of adsorption energy, forming of a film at a molecule level (or an atomic level) is controlled.

Concretely, by controlling the temperature and pressure at the time of film forming, i.e., by repeating the rise and fall of temperature and pressure, unnecessary molecular layers after the second layer, (source gas) are eliminated. By this, a plurality of molecular layers that constitute the desired film, is stacked layer by layer on the forming surface.

Below, the ALD method will be described. Below, an example where titanium nitride (TiN) film is formed applying titanium tetrachloride (TiCl₄) and ammonia (NH₃), will be described.

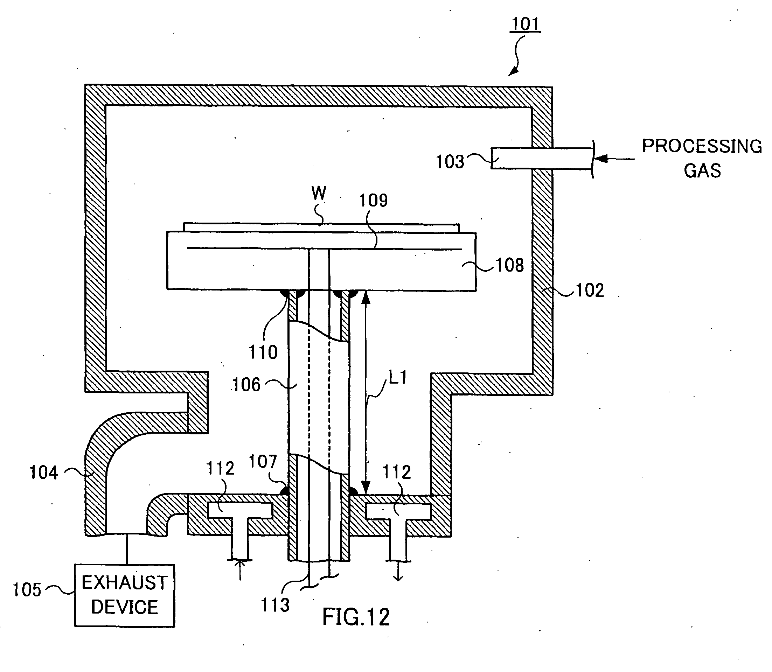

FIG. 12 shows a structure example of a processing device that carries out the above ALD method.

A processing device 101 comprises for example, an approximately cylindrical aluminum chamber 102. The diameter of the under part of the chamber 12 is formed smaller than the diameter of the upper part, and on the side wall of the chamber 102, a nozzle 103 is provided. Processing gas for forming a film is provided to the interior of the chamber 102 via the nozzle 103.

On the lower side wall of the chamber 102, an exhaust device 105 is connected via an exhaust pipe 104. The exhaust device 105 exhausts the gas in the chamber 102.

At the base of the chamber 102, there is provided a cylindrical hollow shaft 106 standing up, such as disclosed in the Unexamined Japanese Patent Application KOKAI Publication No. H7-78766, and the Unexamined Japanese Patent Application KOKAI Publication No. H7-153706. The shaft 106 penetrates the base of the chamber 102. The junction of the chamber 102 and the shaft 106 is sealed by a sealing member 107, such as an O-ring, to retain airtightness in the chamber 102.

On the top part of the shaft 106, a disk form placing table 108 for placing a wafer is fixed. The placing table 108 includes a heater 109, constituted of a metal resistive element that has a predetermined pattern, such as tungsten. The shaft 106 is constituted of the same material as the placing table 108, such as for example, aluminum nitride, and is connected to the placing table 108 by a solid state bonding 110. By this, the interior space of the shaft 106 can be retained at a different atmosphere from the interior space of the chamber 102. The interior space of the shaft 106 is retained by air atmosphere.

The heater 109 is connected to an electric supply line 113 that goes through the interior of the shaft 106, and is provided electric power via the electric supply line 113. As described above, the interior of the shaft 106 is air atmosphere. By this, enough heat liberation of the supply line 113 is carried out, and burn out of the supply line 113 is prevented. Additionally, corrosion of the supply line 113 by processing gas that is provided to the interior of the chamber 102, is prevented.

The shaft 106 has a function that escapes the heat of the placing table 108 that is heated by the heater 109. Namely, the heat of the placing table 108 goes through the shaft 106, and escapes to the base of the chamber 102. There is provided a cooling jacket' 112 at the base of the chamber 102, wherein coolant water flows, as disclosed in the Unexamined Japanese Patent Application KOKAI Publication No. H6-244143. The heat of the shaft 106 is absorbed by the coolant water that flows in the cooling jacket 112.

Next, a process for forming a TiN film by the ALD method, applying the above processing device 101, will be described.

First, the heating table 108 is heated to an adequate temperature, for example 450°C, for the attachment of TiCl₄. Then, TiCl₄ gas is fed for a short time, for example a few seconds, to the interior of the chamber 102. By this, many layers of TiCl₄ molecular layers are attached to the surface of the wafer.

Next, to purge TiCl₄ gas, an inactive gas, for example argon gas, is provided to the interior of the chamber 102, and the interior of the chamber 102 is set to a high vacuum of for example 1.33 × 10⁻³ Pa (10⁻⁵ Torr). At this time, the temperature of the placing table 108 is set to a temperature adequate for the attachment of NH₃, for example 300°C. By this, the TiCl₄ molecule layers that are attached to the surface of the wafer, scatter by the aforementioned difference of adsorption energy, leaving a first layer of molecular layers. As a result, a situation where one layer of TiCl₄ molecular layer is attached to the surface of the wafer is gained.

Next, the NH₃ gas is fed to the interior of the chamber 102, for a short time, for example for a few seconds. By feeding the gas, the pressure in the chamber 102 returns to for example 133 Pa (1 Torr). By this, the TiCl₄ molecules on the surface of the wafer, and the NH₃ gas react, and one layer of TiN molecular layer is formed. Many layers of NH₃ molecular layers are attached to the formed TiN molecular layer.

Next, to purge NH₃ gas, argon gas is once again fed to the interior of the chamber 102, and the pressure in the chamber 102 is set to approximately 1.33 × 10⁻³ Pa. At this time, the placing table 108 is set to for example 450°C. By this, the NH₃ molecular layers of the second layer and more are dispersed, i.e. excluding the NH₃ molecular layer of the first layer that is attached to the TiN molecular layer.

Next, TiCl₄ gas is fed to the interior of the chamber 102, for a few seconds. At this time, the NH₃ molecules on the TiN layer react to the TiCl₄ gas, and one layer of TiN molecular layer is formed. Therefore, at this point, two layers of TiN molecular layers are formed on the surface of the wafer. Many layers of TiCl₄ molecular layers are attached to the formed second layer of TiN molecular layer.

Subsequently, the same operation as the above, namely, the providing of each source gas, and the purging by inactive gas are repeated predetermined times. By this, the TiN molecular layer is stacked layer by layer, and a TiN film with the requested thickness can be gained. The above operation is repeated for example a hundred to several hundreds of times.

As the above, according to the ALD method, because a plurality of molecular layers that constitute a film can be formed layer by layer, the film thickness can be controlled with high precision. Furthermore, a film of a high quality can be gained. Additionally, by changing the film quality of each molecular layer little by little, it is possible to provide a gradient to the attribute of the entire film.

However, the above processing device 101 has the problems of below.

First, the placing table 108 that includes the heater 109 is manufactured by sintering ceramics such as aluminum nitride that includes metal resistive elements. However, because the yielding rate by this manufacturing method is low, the placing table 108 is expensive.

Additionally, it is necessary to form a penetrating hole in the chamber 102, and place the shaft 106, to draw the electric supply line 113 that is connected to the heater 109, outside of the chamber 102. Therefore, the structure of the processing device 101 is complicated.

Furthermore, the sealing member 107 that seals the connection of the chamber 102 and the shaft 106, is ordinarily constituted of resin material. In this case, to avoid damage of the sealing member 107 by heat, it is necessary to make the length L1 of the shaft 106 that functions as a heat liberation member, longer. Namely, the length L1 of the shaft 106 is set so that the temperature of the part of the shaft 106 that contacts the sealing member 107 is equal to, or lower than the heat resistant temperature of the resin material that is applied to the sealing member 107.

If the length L1 of the shaft 106 is long, the capacity of the chamber 102 also becomes larger. Therefore, the exhaustion efficiency in the chamber 102 is low, and a long time is necessary to change the atmosphere in the chamber 102. Namely, by the ALD method that often carries out the changing of atmosphere, a high throughput can not be gained. Furthermore, because the consumption amount of processing gas is large, the manufacturing cost of a semiconductor device and a liquid crystal display device, etc., is high.

As the above, in the conventional processing device 101, there are problems that the manufacturing yielding rate of the placing table 108 is low, and that the structure of the processing device 101 is complicated. Additionally, there are problems that the capacity of the chamber 102 that constitutes the conventional processing device 101 is large, and therefore reduction of the manufacturing cost and improvement of throughput is not enough.

Considering the above, an object of the present invention is to provide a processing device that has a simple structure. Another object of the present invention is to provide a placing member where a high yielding rate can be realized. Still another object of the present invention is to provide a processing device and processing method, in which a low manufacturing cost can be realized. Yet another object of the present invention is to provide a processing device and processing method, in which a high throughput can be realized.

### Disclosure of Invention

To achieve the above objects, a processing device according to a first aspect of the present invention is characterized by comprising:
a chamber (12), where a predetermined processing of a target for processing (W) is carried out in the interior;
a placing member (21) that is placed in the chamber (12), and the target for processing (W) is placed thereon;
an induction coil (27) that is provided on the out side of the chamber (12); and
a power source (28) that forms a magnetic field around the induction coil (27) by passing a current through the induction coil (27);
wherein the placing member (21) has a resistive layer (25) that is heated by induction heating that occurs by the magnetic field formed around the induction coil (27), and heats the target for processing (W), which is placed on the placing member (21).

The processing device may further comprise a reflection film (31) that is provided on an inner surface the chamber (12) and may reflect radiation heat from the resistive layer (25).

The placing member (21) may further comprise a heat insulation layer (26) that may be stacked on the resistive layer (25), and may prevent diffusion of heat generated by the resistive layer (25).

The placing member (21) may further comprise a reflection film (31) that may be provided on the resistive layer (25) and may reflect radiation heat from the resistive layer (25).

The reflection film (31) may be provided in between the resistive layer (25) and the heat insulation layer (26).

The reflection film (31) may be provided on a side face of the resistive layer (25).

The processing device may further comprise a flow path (20) that is placed in between the induction coil (27) and the placing member (21), wherein a cooling medium that absorbs heat from the placing member (21) flows.

The placing member (21) may further comprise an insulation layer (24) that may be stacked on the resistive layer (25) and may constitute a surface for placing the target for processing (W).

The processing device may further comprise a fixing member (22) that fixes the placing member (21) to the interior of the chamber (12).

The processing device may further comprise a gas providing device (29) that provides a plurality of kinds of gas in a predetermined order to the interior of the chamber (12).

The processing device may further comprise a carrier chamber (17) that is connected to the chamber (12), wherein the carrier chamber (17) may comprise a carrier mechanism (18) that transfers the placing member (21), in which the target for processing (W) is placed, to the interior of the chamber (12).

The processing device may further comprise a support member (30) that supports the placing member (21), where the target for processing (W) is placed, in a state apart from an inner surface of the chamber (12).

A processing device according to a second aspect of the present invention is characterized by comprising:
a chamber (12), where a predetermined processing of a target for processing (W) is carried out in the interior;
a retaining member (32) that is provided in the interior of the chamber (12), and retains a plurality of placing members (21), in which the targets for processing (W) are placed;
a carrier mechanism (18) that transfers the plurality of placing members (21), in which the targets for processing (W) are placed, and sets them at the retaining member;
an induction coil (27) that is provided on the out side of the chamber (12); and
a power source (28) that forms a magnetic field around the induction coil (27) by passing a current through the induction coil (27);
wherein each of the plurality of placing members (21) has a resistive layer (25) that is heated by induction heating that occurs by the magnetic field formed around the induction coil (27) and heats the target for processing (W), which is placed on the placing member (21).

A placing member according to a third aspect of the present invention is characterized by comprising an insulation layer (24) and a resistive layer (25) that is stacked on the insulation layer (24), heated by induction heating, and heats a target for processing (W), placed on the insulation (24).

The resistive layer (25) may be formed by melting and spraying conductive material on the insulation layer (24).

The placing member may further comprise a heat insulation layer (26) that may be stacked on the surface, opposite to the surface that contacts the insulation layer (24) of the resistive layer (25), and may prevent diffusion of heat, generated by the resistive layer (25).

The placing member may further comprise a reflection film (31) that may be placed on the resistive layer (25) and may reflect radiation heat from the resistive layer (25).

A processing method according to a fourth aspect of the present invention is characterized by carrying out a predetermined step of a target for processing (W) that is placed in the interior of a chamber (12), and by comprising:
a step of placing the target for processing (W) to one surface of an insulation layer (24) that is placed in the chamber (12), wherein a resistive layer (25) is stacked to the other surface of the insulation layer (24);
a step of heating the resistive layer (25), which is in the chamber (12), by induction heating that occurs by passing a current through an induction coil (27) that is provided out side of the chamber (12), thereby heating the target for processing (W), which is placed on the insulation layer (24).

The processing method may further comprise a step of alternately providing a plurality of kinds of gas to the interior of the chamber (12).

The processing method may further comprise a step of changing a temperature of the target for processing (W) by changing the amplitude of the current that is passed through the induction coil (27).

### Brief Description of Drawings

FIG. 1 is a diagram showing the structure of a processing device according to the first embodiment of the present invention.
FIG. 2 is a diagram showing a timing chart of the performance of the processing device.
FIG. 3 is a diagram showing the structure of a processing device according to the second embodiment of the present invention.
FIG. 4 is a diagram showing the structure of a processing device according to another embodiment of the present invention.
FIG. 5 is a diagram showing the structure of a processing device according to another embodiment of the present invention.
FIG. 6 is a diagram showing the structure of a processing device according to another embodiment of the present invention.
FIG. 7 is a diagram showing the structure of a processing device according to another embodiment of the present invention.
FIGS. 8A to 8C are diagrams showing the forming position of the reflection film placed in the processing device.
FIG. 9 is a diagram showing the structure of a processing device according to another embodiment of the present invention.
FIG. 10 is a diagram showing the structure of a processing device according to another embodiment of the present invention.
FIG. 11 is a diagram showing a placing example of exhaust pipes that constitute the processing device.
FIG. 12 is a diagram showing the structure of a conventional processing device.

### Best Mode for Carrying Out the Invention

### (First Embodiment)

Below, a processing device according to the first embodiment of the present invention will be described with reference to the drawings.

In the first embodiment, an embodiment where the present invention is applied to a processing device that forms a TiN film on a semiconductor wafer (herein after referred to as: wafer W), by an ALD (Atomic Layer Deposition) method will be described.

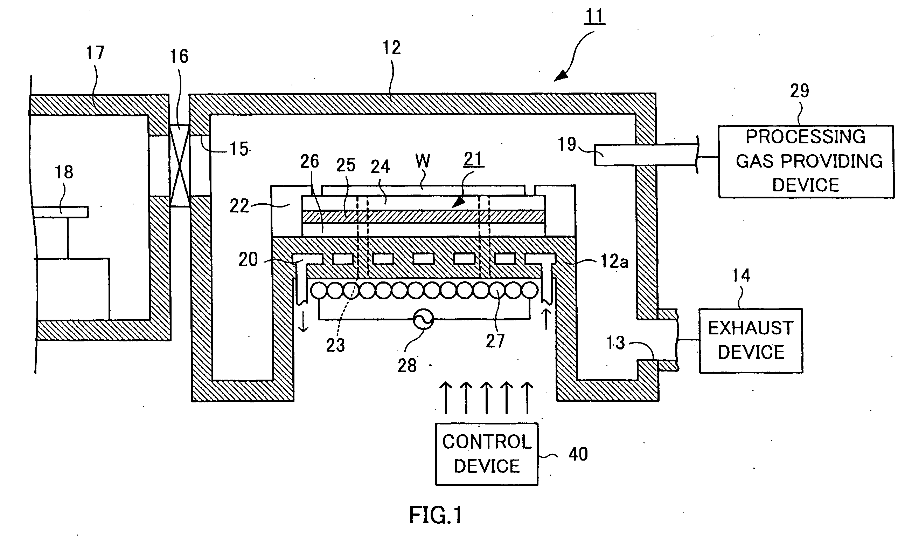

FIG. 1 shows the structure of a processing device 11 according to the first embodiment.

The processing device 11 comprises an approximately cylindrical chamber 12. The chamber 12 is comprised of materials that do not have magnetism; for example, inorganic material such as ceramic, nonmagnetic metal such as aluminum and stainless steel, or resin material such as fiber-reinforced plastic.

The approximately center of the base of the chamber 12 sticks out, and forms a stage portion 12a, wherein the upper surface thereof is approximately flat. By this, as shown in FIG. 1, an annular groove that surrounds the sticking out stage portion 12a is formed below the chamber 12. Looking from the outside of the chamber 12, a depression is formed at approximately the center of the base of the chamber 12.

On the lower side wall of the chamber 12, an exhaust device 14 is connected via an exhaust pipe 13. The exhaust device 14 is constituted of a turbo-molecular pump, dry pump, etc., and exhausts gas in the chamber 12.

On the other hand, on the upper side wall of the chamber 12, a gate 15 is provided. The gate 15 is connected to a carrier chamber 17 that is next to the chamber 12, through a gate valve 16. The airtight in the chamber 12 is retained by closing the gate valve 16.

The carrier chamber 17 is provided as a port to transfer in and transfer out wafers W to the chamber 12. A carrier mechanism 18 that is constituted of carrier arms, etc., is placed in the carrier chamber 17. The carrier mechanism 18 transfers in the wafers W to the chamber 12, and also transfers out the wafers W from the chamber 12.

On the upper side wall of the chamber 12, a processing gas providing device 29 is connected through a nozzle 19 made of quartz, etc. The processing gas providing device 29 provides processing gas, which is used in the later described film forming processing, to the interior of the chamber 12. As will be later described, the processing gas are titanium tetrachloride (TiCl₄), ammonia (NH₃), and argon (Ar). A showerhead may be applied instead of the nozzle 19, and the nozzle 19 may be plurally provided according to the kind of gas.

In the stage portion 12a of the chamber 12, a cooling jacket 20 is provided. The cooling jacket 20 is comprised of a passage where a cooling medium, such as coolant, etc., flows. A cooling medium that is adjusted to a predetermined temperature flows through the cooling jacket 20.

On the stage portion 12a of the chamber 12, a susceptor 21 that is formed in a disk form is provided. The susceptor 21 is a member for placing a wafer that is a target for processing, and has a function to heat the placed wafer W. The susceptor 21 is fixed to the stage portion 12a at the rim parts thereof by clamp members 22 that are fixed to the stage portion 12a by screws, etc.

A plurality of lift pin holes 23, for example three lift pin holes 23 are formed penetrating the stage portion 12a and the susceptor 21. In the lift pin holes 23, lift pins (not shown in the drawings), are inserted, and the interior of the lift pin holes are structured so that the lift pin moves up and down.

In a case where the wafer W is transferred in to the chamber 12 by the carrier mechanism 18, and in a case where the wafer W is transferred out of the chamber 12, the lift pin moves up. The wafer W that is transferred in is placed on the susceptor 21 by the lift pin moving down.

The susceptor 21 is constituted of an insulation layer 24, a resistive layer 25, and a heat insulation layer 26.

The insulation layer 24 is formed by sintering ceramic material, such as aluminum nitride, silicon nitride, or silicon carbide. One surface of the insulation layer 24 is flat, and structures the surface of the susceptor 21 (the surface for placing the wafer W).

The resistive layer 25 is stacked on the other surface of the insulation layer 24. The resistive layer 25 is constituted by conductive material with a comparatively high resistance, for example, pure metal such as tungsten, molybdenum, nickel, tantalum or platinum, alloyed metal such as nickel chrome alloy or iron chrome alloy, ceramic such as silicon carbide or nitride boride, or carbon such as graphite, etc. In a case where dry cleaning applying halogen gas such as chlorine and fluorine is carried out in the chamber 12, it is preferable to apply materials that have tolerance to halogen radicals.

The resistive layer 25 is formed by for example melting and spraying the aforementioned conductive material to the insulation layer 24. The resistive layer 25, as will be described later on, generates heat by electromagnetic induction, and heats the wafer W that is placed on the insulation layer 24.

The heat insulation layer 26 is stacked on the resistive layer 25. The heat insulation layer 26 is constituted by low heat conductance material, such as foamed quartz or porous alumina. The heat insulation layer 26 is formed for example, by melting and spraying these material to the resistive layer 25. The heat insulation layer 26 constitutes the back side of the susceptor 21. The susceptor 21 is placed so that the heat insulation layer 26 contacts the stage portion 12a of the chamber 12. The heat insulation layer 26 represses the heat conductance from the susceptor 21 to the chamber 12.

On the outside of the chamber 12, an induction coil 27, formed in a spiral; is provided adjacent to the stage portion 12a of the chamber 12. The induction coil 27 is evenly placed so that it is approximately parallel to the resistive layer 25. As will be later described, the resistive layer 25 generates heat by a magnetic field generated by the induction coil 27, and as a result, the wafer W on the susceptor 21 is heated.

The induction coil 27 is connected to an alternator 28. When a current passes through the induction coil 27, a magnetic field is formed around the induction coil 27. By the formed magnetic field, the resistive layer 25 is heated. Concretely, by the formed magnetic field, an eddy current occurs in the resistive layer 25. When a current passes through the resistive layer 25, the resistive layer 25 generates heat based on an electric resistance that the resistive layer 25 has. By this, the entire susceptor 21 is heated, and the wafer W on the susceptor 21 is heated.

The alternator 28 applies to the induction coil 27, high frequency power of for example a frequency of a few dozen Hz to 400 Hz, and a power of 500 W to 1500 W. The temperature of the resistive layer 25 is controlled by changing the frequency and/or power of the electric power that is applied, i.e., is controlled by changing the amplitude of the current that is to be passed through the induction coil 27.

Here, the cooling jacket 20 absorbs the heat that transmits from the susceptor 21 to the chamber 12, and maintains the temperature of the chamber 12 approximately constant.

The processing device 11 comprises a control device 40 that is constituted by a micro computer. The control device 40 stores programs and data for forming a TiN film on the wafer W. The control device 40 controls the entire operation of the processing device 11, according to the stored programs, and forms a TiN film on the wafer W. Concretely, the control device 40 controls the exhaust device 14, the carrier mechanism 18, the alternator 28, and the processing gas providing device 29, and carries out conveyance of wafers W, control of the pressure in the chamber 12, heating of the wafers W, and providing of processing gas, etc.

As the above, by heating the resistive layer 25 by induction heating, it is not necessary to draw in wirings for passing currents through the resistive layer 25 to the interior of the chamber 12. In other words, it is not necessary to provide a hollow shaft for drawing in the wirings, and seal members that are correspondingly necessary. Therefore, it is not necessary to consider the heat-resistant temperature of the sealing members, and the susceptor 21 can be placed near the chamber 12. As a result, a chamber 12 with a small capacity is realized.

Furthermore, because the capacity of the chamber 12 is small, the amount of consumption of processing gas is reduced. By this, low production cost can be realized.

Moreover, because the whole heat capacity, including the susceptor 21, is small, for there aren't any shafts, etc., the time needed to heat and cool is short. Namely, the response to the change of temperature is good. Therefore, the temperature of the wafer W can be controlled at a high precision, and a processing of a high throughput and a highly reliable processing can be carried out.

The susceptor 21 is formed by stacking the resistive layer 25 and the heat insulation layer 26 on the insulation layer 24 that is constituted by ceramic, etc. By this, the susceptor 21 can be created far more easily with a high yielding rate, compared to a case where insulating material that involves resistive elements, is sintered. As a result, an inexpensive susceptor 21 can be realized.

Furthermore, induction heating has a higher heat conversion efficiency of electric power, than by connecting wiring to the resistive element and passing currents through. Namely, by applying induction heating, low production cost and running cost can be realized.

Next, the operation of the processing device 11 that has the above structure will be described.

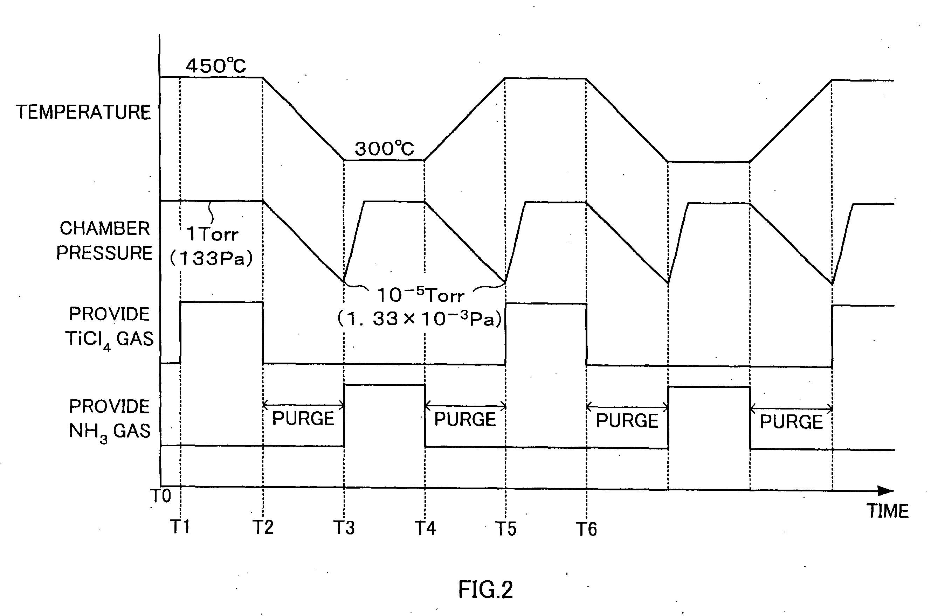

FIG.2 is a timing chart of the operation conducted by the processing device 11. The operation indicated below are controlled by the control device 40. The operation indicated below is just an example, and as long as the same result is gained, can be any kind of operation.

First, the carrier mechanism 18 transfers in the wafer W that is a processing target to the interior of chamber 12, and places it on a lift pin (not shown). The transferred in wafer W is placed on the suscpetor 21, by the lift pin moving down.

When the wafer W is placed on the susceptor 21, the alternator 28 applies high frequency power of a predetermined frequency and predetermined power to the induction coil 27. By this, a current passes through the induction coil 27, and a magnetic filed is formed around the induction coil 27. The resistive layer 25 of the susceptor 21 is heated by the formed magnetic field, and heats the wafer W placed on the susceptor 21 to a temperature that is adequate to the adhesion of TiCl₄, for example to 450°C (Time T0).

Subsequently, the processing gas providing device 29 feeds TiCl₄ gas to the interior of the chamber 12 through the nozzle 19 for a short time, for example, a few seconds, concretely for 5 to 10 seconds. Here, if necessary, the TiCl₄ gas may be fed together with carrier gas. By this, many layers of TiCl₄ molecular layers are attached to the surface of the wafer W (Time T1 to T2).

Next, to purge TiCl₄ gas, the processing gas providing device 29 provides Ar gas to the interior of the chamber 12. Then, the exhaust device 14 exhausts the gas in the chamber 12, and reduces the pressure in the chamber 12 to for example 1.33 × 10⁻³ Pa (10⁻⁵ Torr). The alternator 28 sets the temperature of the susceptor 21 to a temperature adequate for the attachment of NH₃, for example 300°C, by changing the frequency and power of the electric power that is to be applied to the induction coil 27 (Time T2 to T3).

By this, the TiCl₄ molecular layers that are attached to the surface of the wafer W, scatters leaving a first layer of molecular layers, according to the difference of the attachment energy that the molecular layer of the first layer has and the attachment energy that the molecular layers of the layers after the second layer have. As a result, a situation where one layer of TiCl₄ molecular layer is attached to the surface of the wafer W is gained.

Next, the processing gas providing device 29 provides NH₃ gas to the interior of the chamber 12 for a short time, for example, a few seconds, concretely, for 5 to 10 seconds. The exhaust device 14 exhausts the gas in the chamber 12, and sets the pressure in the chamber 12 to for example 133 Pa (1 Torr). Here, if necessary, the NH₃ gas may be fed together with carrier gas. The TiCl₄ molecules on the surface of the wafer W, and the NH₃ gas react, and one layer of TiN molecular layer is formed. At this time, many layers of NH₃ molecular layers are attached to the formed TiN molecular layer (Time T3 to T4).

Next, to purge NH₃ gas, the processing gas providing device 29 provides Ar gas to the interior of the chamber 12. Then, the exhaust device 14 exhausts the gas in the chamber 12, and reduces the pressure in the chamber 12 to approximately 1.33 × 10⁻³ Pa. The alternator 28 rises the temperature of the susceptor 21 to 450°C, by changing the frequency and power of the electric power that is to be applied to the induction coil 27. By this, the NH₃ molecular layers of the second layer and more are eliminated, i.e. excluding the NH₃ molecular layer of the first layer that is attached to the TiN molecular layer (Time T4 to T5).

After purging, the processing gas providing device 29 feeds TiCl₄ gas to the interior of the chamber 12 for a few seconds (for example 5 to 10 seconds). By this, the NH₃ molecules that are left on the TiN molecular layer reacts to the TiCl₄ gas, and a layer of TiN molecular layer is formed. At this time, many layers of TiCl₄ molecular layers are attached to the formed TiN molecular layer. At this point, two layers of TiN molecular layers are formed on the surface of the wafer W (Time T5 to T6).

Subsequently, the processing device 11 repeats the same operation of the above, namely, provides each gas, and purges, a predetermined times. By this, the TiN molecular layer is stacked layer by layer, and a TiN film with the requested thickness can be gained. The processing device 11 repeats the operation of the above for example a hundred to several hundreds of times.

After film forming processing, the carrier mechanism 18 transfers the wafer W out of the chamber 12 to the carrier chamber 17. The processing is thus ended.

In the above ALD method, changing of atmosphere in the chamber 12 is carried out many times. Consequently, exhaustion efficiency of the chamber 12 effects the throughput greatly. However, because the above processing device 11 heats the resistive layer 25 by induction heating, it is not necessary to provide a hole for wiring in the chamber 12. Therefore, it is not necessary to apply a sealing member that is necessary for sealing. Consequently, it is not necessary to provide space for heat liberation in the chamber 12, and a suceptor 21 with a high temperature can be provided close to the wall surface of the chamber 12. By this, a chamber 12 with a small capacity can be realized. As a result, high exhaustion efficiency and high throughput can be realized.

Additionally, in the above ALD method, the rise and fall of temperature of the wafer W is frequently repeated. In a case where induction heating is applied, because there isn't a hollow shaft, etc., for bringing in the wiring, the entire heat capacity including the susceptor 21 is small. Therefore, the temperature change of the susceptor 21 and the wafer W shows a good response. By this, reaction for film forming can be controlled more precisely, and a precise film forming can be possible. Furthermore, a high throughput can be gained.

As described above, in a case where the resistive layer 25 is heated by induction heating, a chamber 12 that has a simple structure and small capacity can be realized. As a result, a high exhaustion efficiency can be gained, and a high throughput can be gained especially in the ALD method where change of atmosphere is carried out many times.

Additionally, by not applying a hollow shaft, etc., for bringing in the wirings, the whole heat capacity is small, and the heating/cooling of the wafer W can be carried out accurately. Furthermore, a suscpetor 21 that comprises a stacking structure can be manufactured relatively easily. Moreover, induction heating has high efficiency of converting electric power to heat, and processing can be possible with a low cost.

Here, the result of a heat-resistance test of the resistive layer 25 will be shown. The heat-resistance test was conducted by forming a resistive layer 25 of tungsten, etc., on one side of an aluminum nitride plate that has a thickness of 1mm to 5mm, and heating the layer'to 450°C. Resultantly, the maximum warp amount of the resistive layer 25 was less or equal to 10 micrometers. From this result, it can be seen that a structure, stacking the resistive layer 25 on an insulator (ceramic), has a high heat resistance.

In the processing device 11 of the above first embodiment, a gap in between the chamber 12 and the susceptor 21 may be formed to raise the heat insulation between the chamber 12 and the susceptor 21. Furthermore, a gas flow path for flowing inactive gas to the gap may be formed.

To heighten the heat conductance between the wafer W and the susceptor 21, heat conductance gas made of inactive gas, may be flowed between the wafer W and the susceptor 21.

### (Second Embodiment)

Below, the processing device 11 according to the second embodiment will be described with reference to the drawings.

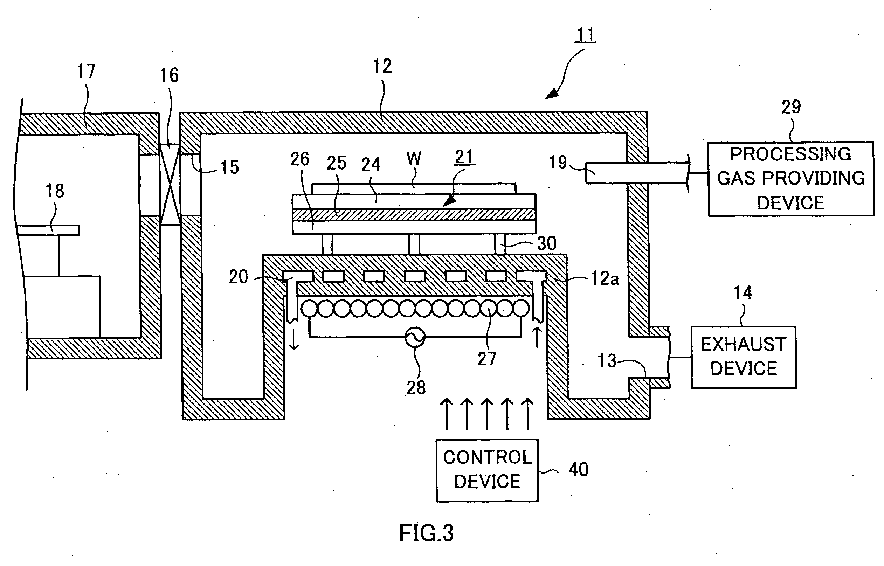

FIG. 3 shows the structure of the processing device 11 according to the second embodiment. To make understanding easier, the same reference numbers as FIG. 1 are placed to the reference numbers in FIG. 3 for the same parts, and descriptions for the overlapping parts will be omitted.

In the second embodiment, the same susceptor 21 as the first embodiment, can be transported. Namely, the wafer W is for example, placed on the susceptor 21 in the carrier chamber 17, and transferred to the interior of the chamber 12 together with the susceptor 21.

Here, the wafer W is placed on the susceptor 21, or is lifted by the susceptor 21, by a carrier mechanism 18 that comprises a Bernoulli chuck.

As shown in FIG. 3, a virgate support member 30 having a predetermined length, is provided to the stage portion 12a of the chamber 12. The support member 30 is plurally placed, for example three are placed, and are placed to support the susceptor 21 where the wafer W is placed. The carrier mechanism 18 is inserted in a space between the susceptor 21 and the chamber 12, formed by the support members 30, and places the susceptor 21 on the support members 30, or lifts the suscpetor 21 from the supporting members 30.

On the outside of the chamber 12, in the same way as the first embodiment, the induction coil 27 is placed next to the stage portion 12a. When a current passes through the induction coil 27, a magnetic field is formed around the induction coil 27. Even if the susceptor 21 is not fixed to the chamber 12, the resistive layer 25 of the susceptor 21 is heated by the formed magnetic field, in the same way as the first embodiment. In other words, even if the susceptor 12 is not fixed in the chamber 12, the resistive layer 25 of the susceptor 21 is heated by induction heating.

By the susceptor 21 being transferable, it is not necessary to provide transfer mechanism such as a lift pin, etc., to the chamber 12. Therefore, because a lift pin hole 23 is not provided to the chamber 12, the structure of the chamber 12 becomes more simple.

In the first and second embodiment, the processing device 11 of a single wafer system is shown as an example. However, the present invention may also be applied to a processing device of a batch system, where a plurality of wafers W are processed at the same time.

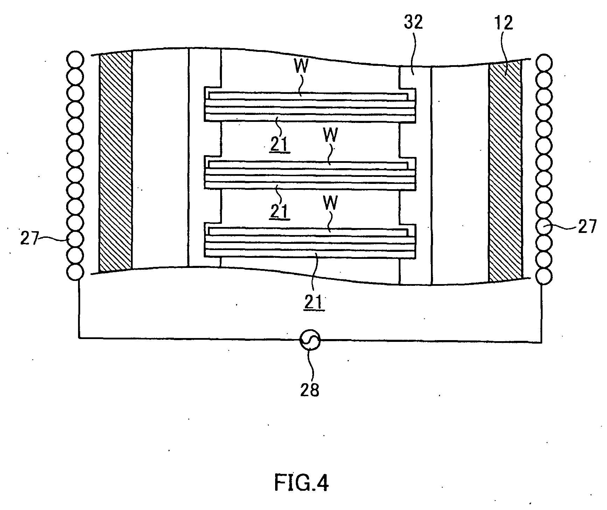

In this case, the same susceptor 21 as the second embodiment thereof, are plurally provided. In the chamber 12, for example, as shown in FIG. 4, a wafer boat 32 of the same kind that is applied in an ordinary processing device of a batch system is provided. The carrier mechanism 18 sets the suceptors 21, in which the wafers W are placed, to the wafer boat 32, which is in the chamber 12. The induction coil 27 is placed surrounding the plurality of wafers W and susceptors 21. By this, the plurality of susceptors 21 are heated by induction heating, and a plurality of wafers W can be easily heated.

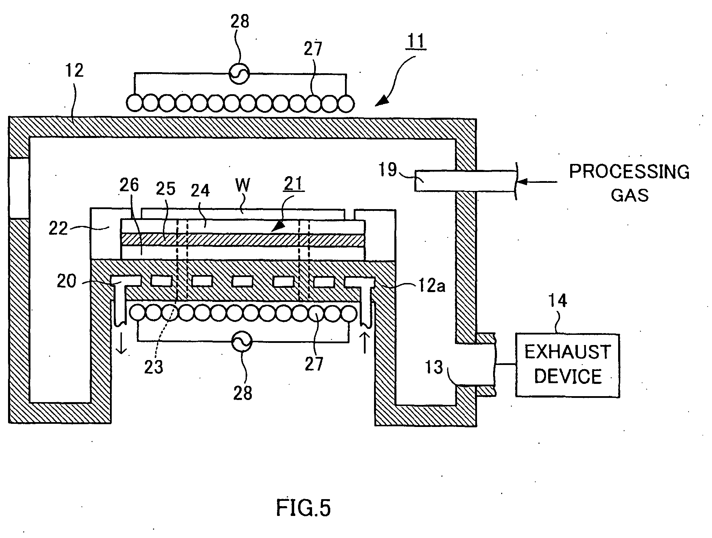

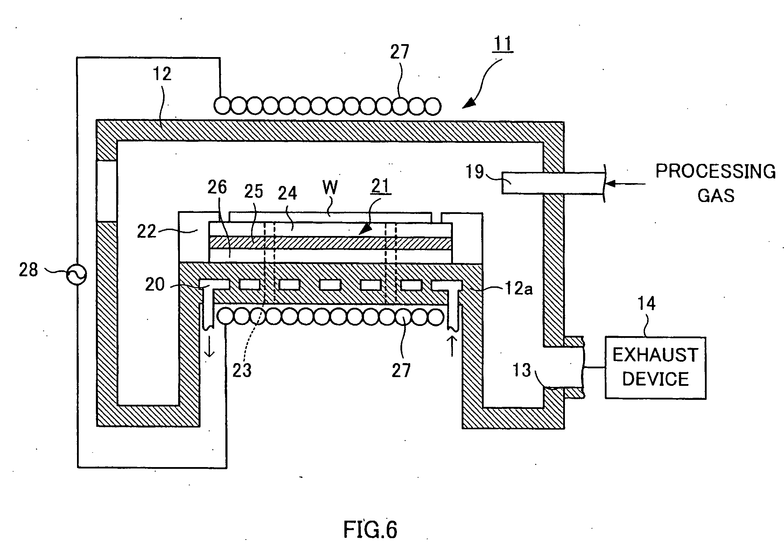

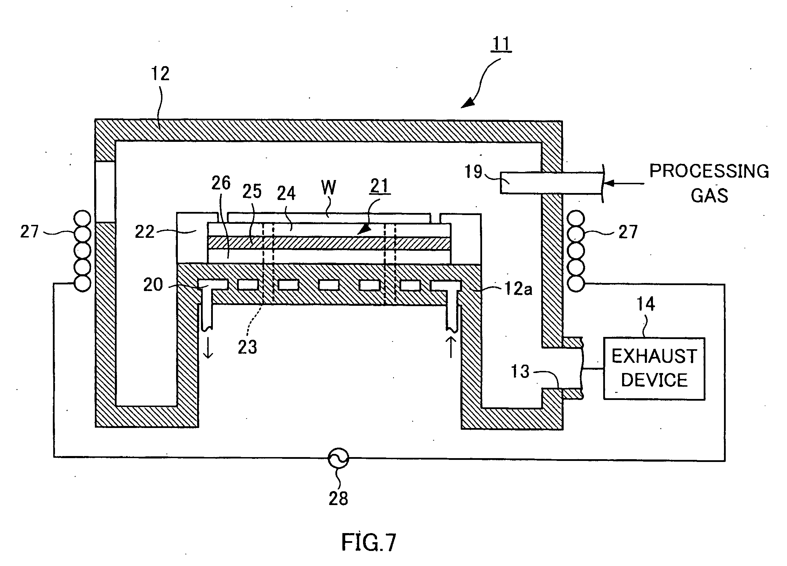

The induction coil 27 indicated in the first and second embodiment, as shown in FIG. 5, may be placed above and below the susceptor 21. Furthermore, as shown in FIG. 6, the induction coil 27 may be placed so that it surrounds the susceptor 21 vertically, or as shown in FIG. 7, may be placed so that it surrounds the susceptor 21 horizontally.

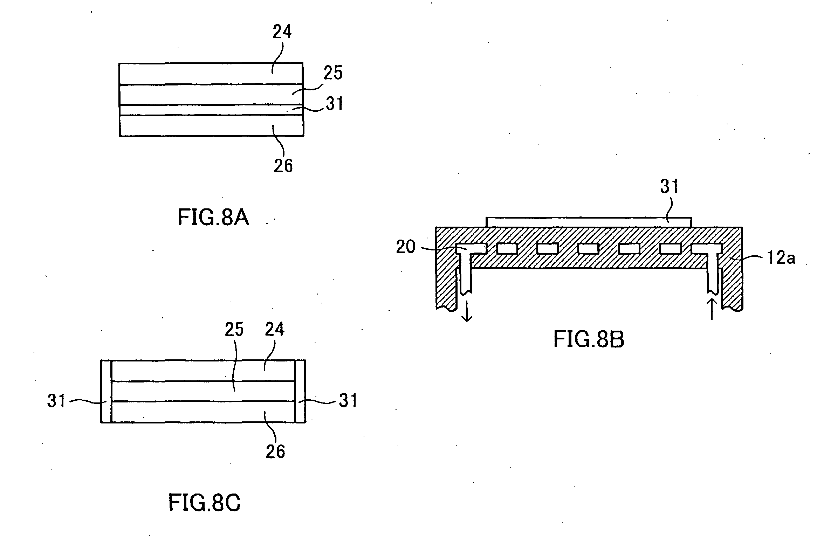

In the first and second embodiment, the heat insulation layer 26 is placed directly on top of the resistive layer 25. However, as shown in FIG. 8A, the resistive layer 25 may be coated by a reflection film 31 constituted by material that reflects radiation heat (for example aluminum or gold, etc.), and the resistive layer 25 may be placed thereon. By doing so, the radiation heat from the resistive layer 25 is reflected by the reflection film 31, and radiation to the back side of the susceptor 21 is more repressed. By this, over heating of the chamber 12 is prevented, and heating efficiency can be raised. If the processing temperature is 400°C or less, aluminum may be suitably applied.

The reflection film 31 may be placed anywhere as long as it is between the resistive layer 25 and the chamber 12. For example, as shown in FIG. 8B, the reflection film 31 may be formed on the surface of the stage portion 12a, where the susceptor 21 is placed. Or, as shown in FIG. 8C, the reflection film 31 may be formed covering the side part of the susceptor 21.

Furthermore, the side part of the suceptor 21 may be covered by insulating material, such as aluminum nitride.

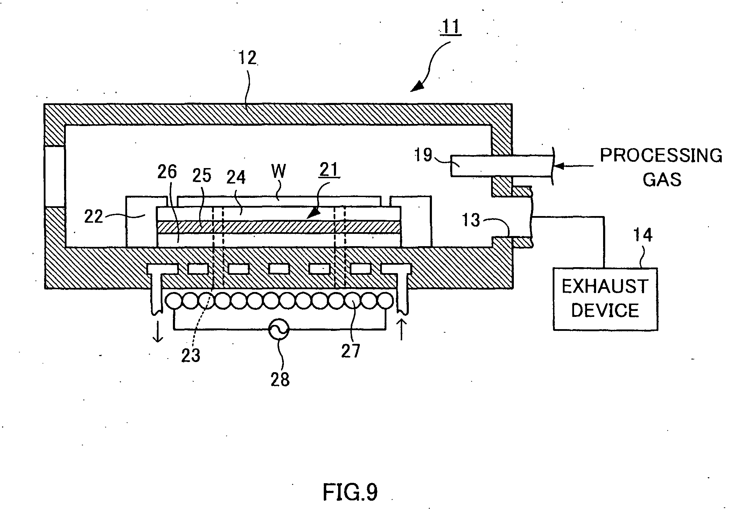

The bottom part of the chamber 12, which is shown in the first and second embodiment, may be flat, as shown in FIG. 9, if it is possible to place the induction coil 27. By doing so, the capacity of the chamber 12 can be made more smaller.

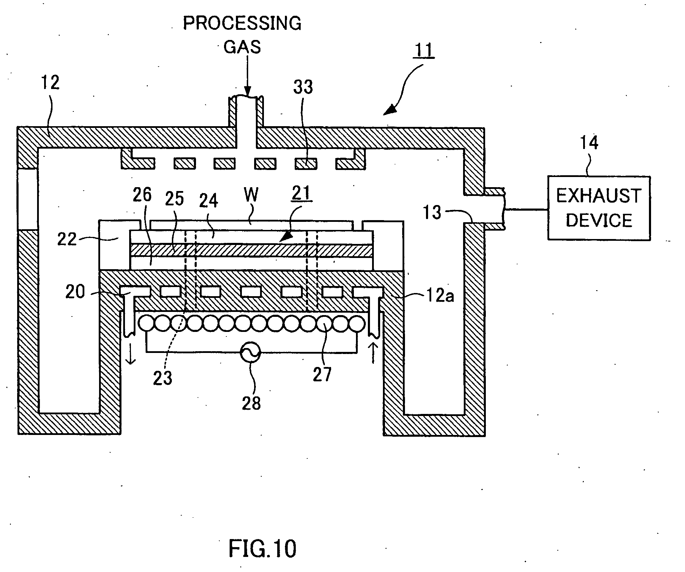

In the first and second embodiment, for example as shown in FIG. 10, a showerhead 33 may be placed instead of the nozzle 19, and the exhaust pipe may be placed at the same height as the wafer W placed on the susceptor 21. The height that is the same as the wafer W, is for example a height, in between the height where the lower end of the exhaust pipe 13 is equal to the surface of the wafer W and the height where the upper end of the exhaust pipe 13 is equal to the surface of the wafer W.

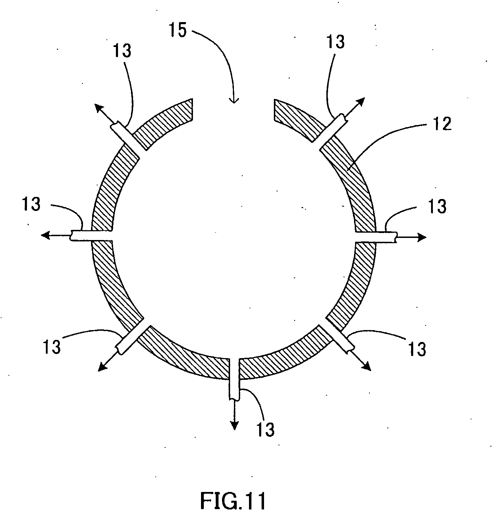

In the first and second embodiment, a plurality of exhaust pipes 13, for example as shown in the plane view of FIG.11, may be provided.

The structure of the processing device 11 indicated above may be applied by being combined. For example, the exhaust pipe 13 shown in FIG. 10 may be plurally provided, as indicated in FIG.11.

In the above, a case where a TiN film is formed on the wafer W by applying TiCl₄ and NH₃ in the ALD method, is described as an example. However, the kind of gas and film are not limited to these. The present invention can be applied to another film forming device, etching device, heat processing device, etc., or any kind of processing device, as long as it is a processing device that maintains the target for processing at a predetermined temperature, and carries out processing. The target for processing is not limited to a semiconductor wafer, and may be substrates, etc., applied in liquid crystal displays.

The present invention is based on the Japanese Patent Application No. 2002-113414, filed with the Japan Patent Office on April 16, 2002, and including specification, claims, drawings and summary. The disclosure of the above Japanese Patent Application is incorporated herein by reference in its entirety.

### Industrial Applicability

The present invention is applicable in the industrial field that applies processing devices, which heats targets for processing, such as semiconductor wafers, etc.

## Claims

1. A processing device **characterized by** comprising:
a chamber (12), where a predetermined processing of a target for processing (W) is carried out in the interior;
a placing member (21) that is placed in said chamber (12), and said target for processing (W) is placed thereon;
an induction coil (27) that is provided on the out side of said chamber (12); and
a power source (28) that forms a magnetic field around the induction coil (27) by passing a current through said induction coil (27);
wherein said placing member (21) has a resistive layer (25) that is heated by induction heating that occurs by the magnetic field formed around said induction coil (27) and heats said target for processing (W), which is placed on the placing member (21).

2. The processing device according to claim 1, **characterized by** further comprising a reflection film (31) that is provided on an inner surface of said chamber (12) and reflects radiation heat from said resistive layer (25).

3. The processing device according to claim 1, **characterized in that** said placing member (21) further comprises a heat insulation layer (26) that is stacked on said resistive layer (25) and prevents diffusion of heat generated by said resistive layer (25).

4. The processing device according to claim 3, **characterized in that** said placing member (21) further comprises a reflection film (31) that is provided on said resistive layer (25) and reflects radiation heat from said resistive layer (25).

5. The processing device according to claim 4, **characterized in that** said reflection film (31) is provided in between said resistive layer (25) and said heat insulation layer (26).

6. The processing device according to claim 4, **characterized in that** said reflection film (31) is provided on a side face of said resistive layer (25).

7. The processing device according to claim 3, **characterized by** further comprising a flow path (20) that is placed in between said induction coil (27) and said placing member (21), wherein a cooling medium that absorbs heat from said placing member (21) flows.

8. The processing device according to claim 7, **characterized in that** said placing member (21) further comprises an insulation layer (24) that is stacked on said resistive layer (25) and constitutes a surface for placing said target for processing (W).

9. The processing device according to claim 8, **characterized by** further comprising a fixing member (22) that fixes said placing member (21) to the interior of said chamber (12).

10. The processing device according to claim 9, **characterized by** further comprising a gas providing device (29) that provides a plurality of kinds of gas in a predetermined order to the interior of said chamber (12).

11. The processing device according to claim 1, **characterized by** further comprising a carrier chamber (17) that is connected to said chamber (12), wherein said carrier chamber (17) comprises a carrier mechanism (18) that transfers said placing member (21), in which said target for processing (W) is placed, to the interior of the chamber (12).

12. The processing device according to claim 11, **characterized by** further comprising a support member (30) that supports said placing member (21), where said target for processing (W) is placed, in a state apart from an inner surface of said chamber (12).

13. A processing device **characterized by** comprising:
a chamber (12), where a predetermined processing of a target for processing (W) is carried out in the interior;
a retaining member (32) that is provided in said chamber (12), and retains a plurality of placing members (21), in which said targets for processing (W) are placed;
a carrier mechanism (18) that transfers said plurality of placing members (21), in which said targets for processing (W) are placed, and sets them at said retaining member (32);
an induction coil (27) that is provided on the out side of said chamber (12); and
a power source (28) that forms a magnetic field around the induction coil (27) by passing a current through said induction coil (27);
wherein each of said plurality of placing members (21) has a resistive layer that is heated by induction heating that occurs by the magnetic field formed around said induction coil (27) and heats said target for processing (W), which is placed on the placing member (21).

14. A placing member **characterized by** comprising an insulation layer (24) and a resistive layer (25) that is stacked on said insulation layer (24), heated by induction heating, and heats a target for processing (W), placed on said insulation (24).

15. The placing member according to claim 14, **characterized in that** said resistive layer (25) is formed by melting and spraying conductive material on said insulation layer (24).

16. The placing member according to claim 15, **characterized by** further comprising a heat insulation layer (26) that is stacked on a surface, opposite to a surface that contacts the insulation layer (24) of the resistive layer (25), and prevents diffusion of heat, generated by said resistive layer (25).

17. The placing member according to claim 16, **characterized by** further comprising a reflection film (31) that is placed on said resistive layer (25), and reflects radiation heat from the resistive layer (25).

18. A processing method **characterized by** carrying out a predetermined processing of a target for processing (W) that is placed in the interior of a chamber (12), and by comprising:
a step of placing said target for processing (W) to one surface of an insulation layer (24) that is placed in said chamber (12), wherein a resistive layer (25) is stacked to the other surface of the insulation layer (24);
a step of heating said resistive layer (25), which is in the chamber (12), by induction heating that occurs by passing a current through an induction coil (27) that is provided out side of said chamber (12), thereby heating said target for processing (W), which is placed on said insulation layer (24).

19. The processing method according to claim 18, **characterized by** further comprising a step of alternately providing a plurality of kinds of gas to the interior of said chamber (12).

20. The processing method according to claim 19, **characterized by** further comprising a step of changing a temperature of said target for processing (W) by changing the amplitude of the current that is passed through said induction coil (27).
